# EUROPEAN PATENT SPECIFICATION

(11) **EP 2 226 934 B1**
(45) Date of publication and mention of the grant of the patent: **30.11.2016**
(21) Application number: 08863984.4
(22) Date of filing: 23.10.2008
(51) Int. Cl.: H01L 41/312, H01L 41/257, H03H 3/02, H03H 3/08

(54) **COMPOSITE PIEZOELECTRIC SUBSTRATE MANUFACTURING METHOD**
VERFAHREN ZUR HERSTELLUNG EINES PIEZOELEKTRISCHEN VERBUNDSUBSTRATS
PROCÉDÉ DE FABRICATION DE SUBSTRAT PIÉZOÉLECTRIQUE COMPOSITE

(30) Priority: 25.12.2007 JP 2007333044
(43) Date of publication of application: 08.09.2010
(73) Proprietor: Murata Manufacturing Co. Ltd., Kyoto 617-8555 (JP)
(72) Inventor: KANDO, Hajime, Nagaokakyo-shi Kyoto 617-8555 (JP); YOSHII, Yoshiharu, Nagaokakyo-shi Kyoto 617-8555 (JP)
(74) Representative: Delumeau, François Guy
(86) International application number: PCT/JP2008/069212
(87) International publication number: WO 2009/081651

(56) References cited:
- JP-A- 11 055 070
- JP-A- 2002 261 582
- JP-A- 2003 017 967
- JP-A- 2004 343 359
- US-A1- 2004 226 162
- SOLAL M ET AL: "Oriented lithium niobate layers transferred on 4" (100) silicon wafer for RF SAW devices", 2002 IEEE ULTRASONICS SYMPOSIUM, 8-11 OCTOBER 2002, MUNICH, GERMANY, 2002, pages 131-134, XP055053523, DOI: 10.1109/ULTSYM.2002.1193369 ISBN: 978-0-78-037582-6

## Description

### Technical Field

The present invention relates to a method for manufacturing a composite piezoelectric substrate, and particularly relates to a method for manufacturing a composite piezoelectric substrate including a piezoelectric film.

### Background Art

In recent, filters and the like using ultrathin piezoelectric materials (ultrathin piezoelectric film) have been actively developed. Although AlN thin films and ZnO thin films formed by a deposition method such as a sputtering method, a CVD method, or the like are generally used as the ultrathin piezoelectric films of filters and the like, any one of the films is a C-axis oriented film in which the C-axis is aligned in the vertical direction of a substrate.

On the other hand, it has been proposed to manufacture a composite piezoelectric substrate including a piezoelectric film by bonding a piezoelectric single crystal substrate to a supporting substrate and then thinning the piezoelectric single crystal substrate by polishing.

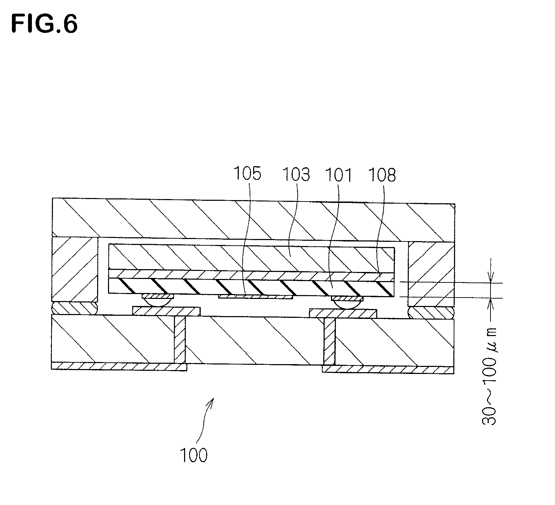

For example, a surface acoustic wave device 100 shown in a sectional view of Fig. 6 includes a piezoelectric substrate 101 composed of a single crystal and having an excitation electrode 105 formed thereon, the piezoelectric substrate 101 being thinned by polishing in a state that the piezoelectric substrate 101 is previously bonded to a protective substrate 103 through a glass layer 108 (refer to, for example, Patent Document 1 and Non-Patent Document 1).

In addition, a method has been proposed, in which hydrogen ions are implanted into a piezoelectric substrate, the piezoelectric substrate and a supporting substrate are placed in a wet atmosphere to form hydrophilic groups on a surface of each of the substrates and then bonded together, and then the piezoelectric substrate is broken at the depth of ion implantation by high-speed heating to form a piezoelectric thin film (refer to, for example, Patent Document 2).
Patent Document 1: Japanese Unexamined Patent Application Publication No. 2002-16468
Patent Document 2: Japanese Unexamined Patent Application Publication (Translation of PCT Application) No. 2002-534886
Patent Document 3: Japanese Unexamined Patent Application No. 2003-17967

Non-patent Document 1: Y. Osugi et al, "Single crystal FBAR with LiNbO3 and LiTaO3 piezoelectric substance layers", 2007 IEEE MTT-S International Microwave Symposium, p. 873-876
Non-patent Document 2: M. Solal et al, "Oriented lithium niobate layers transferred on 4" (100) silicon wafer for RF SAW devices", 2002 IEEE Ultrasonics Symposium, p. 131-134

### J Disclosure of Invention

### Problems to be Solved by the Invention

However, a piezoelectric film formed by the deposition method has severe limitation on materials in view of the deposition temperature and deposition conditions for forming an oriented film, and AlN is mainly used. Also, the orientation direction of a crystal axis cannot be controlled, and a C-axis oriented film is mainly used, thereby causing difficulty in designing a vibration mode by inclining a piezoelectric axis.

On the other hand, a piezoelectric film formed by polishing a piezoelectric single crystal substrate produces most of the piezoelectric single crystal as polishing waste to be abandoned, thereby causing a low efficiency of material utilization. Further, the thickness of the piezoelectric film depends on variation in the polishing speed and waviness of the substrate before polishing, and thus it is difficult to control the thickness for achieving a uniform thickness, thereby causing low productivity.

Patent Documents 2 and 3 use bonding with hydrophilic groups. This bonding method forms hydrophilic groups on surfaces of the piezoelectric substrate and the supporting substrate so that the substrates are bonded through the hydrophilic groups. Since bonding through the hydrophilic groups is very weak, in order to achieve strong bonding, it is necessary to pass through a step of strengthening the bond between the surfaces of the piezoelectric substrate and the supporting substrate by heating the substrates at a temperature (e.g., 400°C) at which the hydrophilic groups can be decomposed to eliminate hydrogen (H) from the hydrophilic groups.

However, there are problems that gas stays in the bonding interface due to elimination of hydrogen gas after bonding, thereby forming microcavities and that hydrogen gas cannot be sufficiently removed and remains in the piezoelectric crystal, thereby breaking the crystal structure and degrading piezoelectricity. The nonuniformity at the bonding interface due to microcavities or crystal breakage causes generation of heat due to elastic scattering or sound absorption in application to surface acoustic wave filters and bulk acoustic wave filters. This causes deterioration of insertion loss of a filter and deterioration of electric power resistance due to heat generation.

In particular, when LiTaO₃ or LiNbO₃ which is a Li-based piezoelectric material is used, remaining hydrogen causes substitution of Li at a Li site with hydrogen and easily degrades piezoelectricity.

For example, a lithium tantalate or lithium niobate substrate is used as a piezoelectric substrate, and also a lithium tantalate or lithium niobate substrate is used as a supporting substrate. The surfaces of the piezoelectric substrate and the supporting substrate are smoothed by CMP (chemical mechanical polishing), and then the piezoelectric substrate and the supporting substrate are exposed to a wet atmosphere to form hydrophilic groups. The surfaces of the piezoelectric substrate and the supporting substrate are put into contact and bonded together to cause weak bonding with hydrophilic groups. Then, the substrates are heated at 500°C for 1 hour to cause strong bonding by decomposition of hydrophilic groups. A composite piezoelectric substrate formed by this bonding method easily produces separation at the bonding interface when external force is applied before heating at 500°C after weak bonding with hydrophilic groups. On the other hand, bonding is strengthened after heating at 500°C, but visible cavities are formed throughout the bonding interface. In addition, observation of the crystalline arrangement of the bonding interface with TEM (transmission electron microscope) shows cavities of several tens nm and disorder of the crystal arrangement.

Further, when H ions are implanted and a polarization state of LiTaO₃ after heating 400°C is examined with a nonlinear dielectric microscope, it is found that polarization polarities initially arrayed are locally inverted in domain units, degrading piezoelectricity. The piezoelectricity is significantly degraded by heating at a higher temperature of 500°C.

Bonding of LiTaO3 and sapphire substrates using surface cleaning and activation by an Ar beam or the like is known from US 2004/226162 A1.

In consideration of the above-mentioned situation, the present invention is intended to provide a method for manufacturing a composite piezoelectric substrate capable of forming an ultrathin piezoelectric film having a uniform thickness by efficiently using a piezoelectric material.

### Means for Solving the Problems

The present invention provides a method for manufacturing a composite piezoelectric substrate configured as described below.

A method for manufacturing a composite piezoelectric substrate includes: a first step of preparing a piezoelectric substrate and a supporting substrate, a second step of implanting ions from a surface of the piezoelectric substrate to form a defective layer in a region having a predetermined depth from the surface of the piezoelectric substrate, a third step of bonding the supporting substrate to the surface of the piezoelectric substrate after the cleaning activation step to form a substrate bonded body, a fourth step of separating the substrate bonded body at the defective layer formed in the piezoelectric substrate so that a separation layer between the surface of the piezoelectric substrate and the defective layer is separated from the piezoelectric substrate and bonded to the supporting substrate to form a composite piezoelectric substrate, and (f) a fifth step of smoothing the surface of the separation layer of the composite piezoelectric substrate; characterized in that there is further provided: a cleaning activation step of removing impurities adhering to at least one of the surface of the piezoelectric substrate in which the defective layer is formed and a surface of the supporting substrate to directly expose the constituent atoms of the surface and activate it; and a polarization step of polarizing the separation layer (3) of the composite piezoelectric substrate (30) after the second step and before the cleaning activation step or after the cleaning activation step.

When a composite piezoelectric substrate including a separation layer bonded thereto from a piezoelectric substrate is manufactured by the above-described method, an ultrathin piezoelectric material (ultrathin piezoelectric film) can be formed on a surface of the composite piezoelectric substrate. For example, a composite piezoelectric substrate including a piezoelectric ultrathin single crystal film can be manufactured using a single crystal piezoelectric substrate.

The above-described method is capable of reusing, for manufacturing a composite piezoelectric substrate, the piezoelectric substrate after the separation layer is separated. Thus, many composite piezoelectric substrates can be manufactured using a piezoelectric substrate, and the waste of a piezoelectric material can be decreased to decrease the amount of the expensive piezoelectric material used as compared with the case in which a piezoelectric film is formed by polishing a piezoelectric substrate.

In addition, the thickness of the separation layer is determined by the energy of ion implantation and unlike in polishing, and the thickness of a piezoelectric material does not depend on waviness of the substrate, thereby forming a uniform ultrathin film. Therefore, it is possible to produce a composite piezoelectric substrate including an ultrathin piezoelectric film with a uniform thickness formed on a surface thereof.

The method includes a polarization step of polarizing the separation layer of the composite piezoelectric substrate after the second step and before the cleaning activation step or after the cleaning activation step, more preferably after the fifth step.

In this case, variation in ion implantation (dose amount, implantation depth) and breakage of the substrate due to pyroelectric charge excited on the surface of the piezoelectric substrate are avoided in the polarization step.

The present invention also provides a method for manufacturing a composite piezoelectric substrate configured as described below.

A method for manufacturing a composite piezoelectric substrate includes: a first step of preparing a piezoelectric substrate and a supporting substrate, a second step of implanting ions from a surface of the piezoelectric substrate to form a defective layer in a region having a predetermined depth from the surface of the piezoelectric substrate, a third step of bonding the supporting substrate to the surface of the piezoelectric substrate after the cleaning activation step to form a substrate bonded body, a fourth step of separating the substrate bonded body at the defective layer formed in the piezoelectric substrate so that a separation layer between the surface of the piezoelectric substrate and the defective layer is separated from the piezoelectric substrate and bonded to the supporting substrate to form a composite piezoelectric substrate, and (f) a fifth step of smoothing the surface of the separation layer of the composite piezoelectric substrate; characterized in that there is further provided: a cleaning activation step of removing impurities adhering to at least one of the surface of the piezoelectric substrate in which the defective layer is formed and a surface of the supporting substrate to directly expose the constituent atoms of the surface and activate it; and spontaneous polarization shifts constituent atoms of the piezoelectric substrate in a first direction and, in ion implantation in the second step, the ions are implanted in the same direction as said first direction.

In this case, deterioration in piezoelectricity of the piezoelectric substrate due to ion implantation can be suppressed.

Also, elimination of hydrogen remaining at the bonding interface is not required because bonding in the cleaning activation step without using OH groups is not bonding with OH groups by hydrophilization. Therefore, high-temperature heating for a long time for decomposing hydrophilic groups is not required. In addition, generation of gas and formation of microcavities do not occur at the bonding interface, and hydrogen gas does not remain in the piezoelectric crystal. Therefore, breakage of the crystal structure and deterioration of piezoelectricity are suppressed. In particular, when LiTaO₃ or LiNbO₃ which is a Li-based piezoelectric material is used, exchange between Li at a Li ion site and hydrogen due to residual hydrogen is not produced, thereby maintaining piezoelectricity.

By using an ultrathin piezoelectric material of a separation layer of a piezoelectric substrate formed in a composite piezoelectric substrate manufactured by the above-described method, elastic wave devices such as a surface acoustic wave device, a boundary acoustic wave device, a bulk acoustic wave device, a plate wave device, and the like can be formed. When a composite piezoelectric substrate manufactured by the above-described method is used for manufacturing an electronic part including such an elastic wave device, the amount of the expensive piezoelectric substrate used can be decreased.

### Advantages

The method for manufacturing a composite piezoelectric substrate of the present invention is capable of forming an ultrathin piezoelectric film with a uniform thickness by efficiently using a piezoelectric material.

### Brief Description of Drawings

[Fig. 1] Fig. 1 is a sectional view showing steps for manufacturing a composite piezoelectric substrate (Example 1).
[Fig. 2] Fig. 2 is a sectional view showing steps for manufacturing a BAW device (Example 2).
[Fig. 3] Fig. 3 is a sectional view showing steps for manufacturing a BAW device (Example 3).
[Fig. 4] Fig. 4 is a sectional view of a BAW device (Example 3).
[Fig. 5] Fig. 5 is a sectional view showing steps for manufacturing a SAW device (Example 1).
[Fig. 6] Fig. 2 is a sectional view of a surface acoustic wave device (conventional example).

### Reference Numerals

2 piezoelectric substrate
3 separation layer
4 defective layer
10, 10x supporting substrate
30, 30a composite piezoelectric substrate

### Best Mode for Carrying Out the Invention

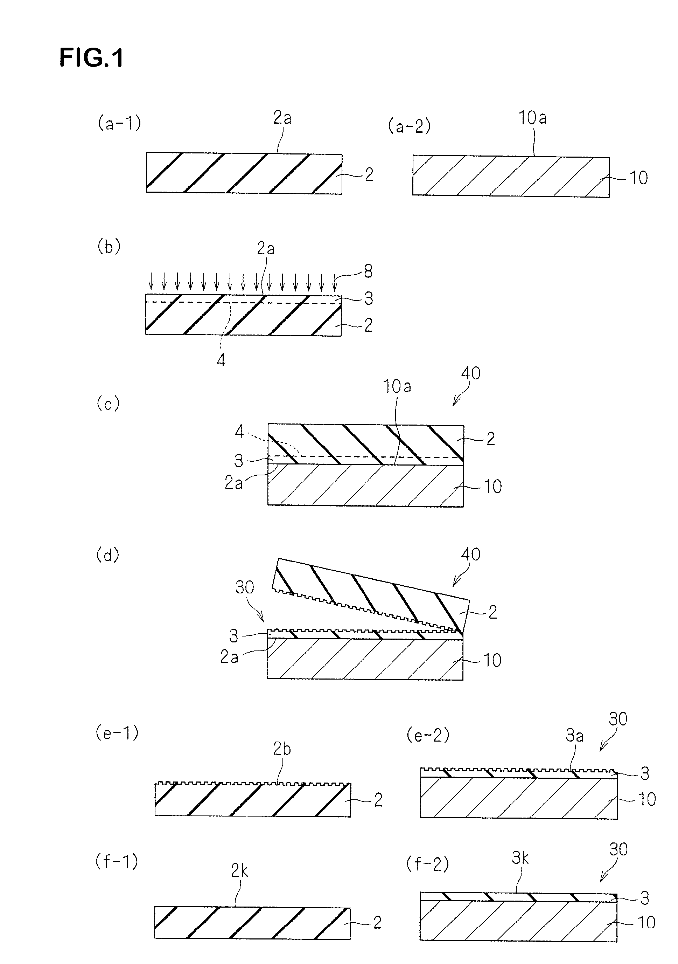

An embodiment of the present invention is described with reference to Figs. 1 to 5.

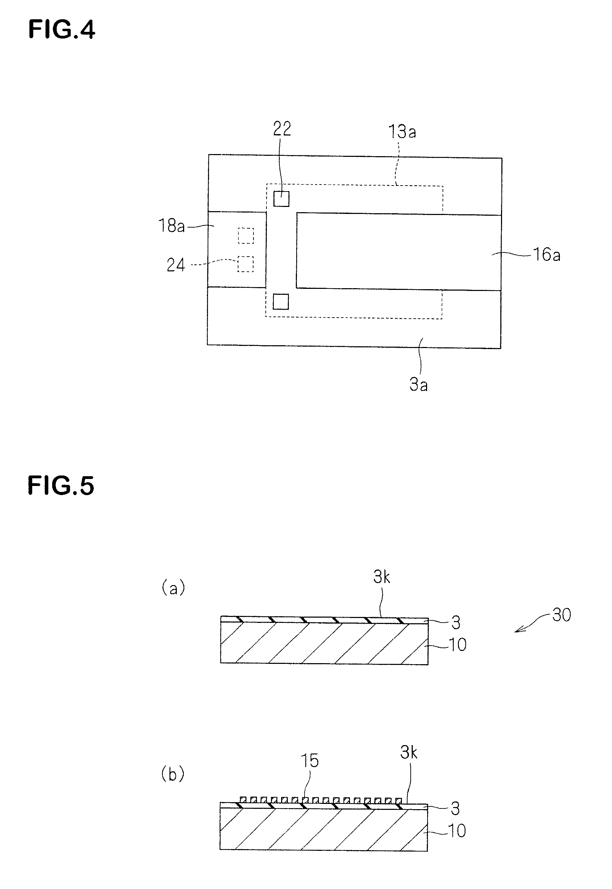

### <EXAMPLE 1> A method for manufacturing a SAW (surface acoustic wave) device of Example 1 is described with reference to Figs. 1 and 5.

First, steps for manufacturing a composite piezoelectric substrate 30 used in a SAW device are described with reference to Fig. 1. Fig. 1 is a sectional view showing steps for manufacturing the composite piezoelectric substrate 30.

(Step 1) As shown in Figs. 1(a-1) and (a-2), a piezoelectric substrate 2 and a supporting substrate 10 are prepared. For example, a 42° Y-cut LiTaO₃ substrate is prepared as the piezoelectric substrate 2, and a Si substrate is prepared as the supporting substrate 10. Surfaces 2a and 10a of the substrates 2 and 10, respectively, are previously polished to mirror surfaces.

(Step 2) Next, as shown by arrows 8 in Fig. 1(b), ions are implanted into a region having a predetermined depth from the surface 2a of the piezoelectric substrate 2 to form a defective layer 4, which is schematically shown by a broken line, in a region having a predetermined depth from the surface 2a of the piezoelectric substrate 2. For example, H⁺ ions are implanted into the LiTaO₃ piezoelectric substrate 2. The implantation energy is 150 Kev, and the dose is 9 x 10¹⁶ cm⁻¹. In this case, the defective layer 4 in which H⁺ ions are distributed from the surface 2a of the piezoelectric substrate 2 to a depth of about 1 µm is formed.

(Cleaning activation step) The piezoelectric substrate 2 and the supporting substrate 10 are placed in a reduced-pressure chamber, and the surfaces 2a ad 10a are irradiated with Ar ion beams to remove impurities such as hydrophilic groups, hydrogen, oxide films, and the like adhering to the surfaces 2a and 10a. The constituent atoms of the substrates 2 and 10 are directly exposed from the surfaces 2a and 10a from which impurities are removed, and thus the surfaces 2a and 10 are activated. When the cleaned activated surfaces 2a and 10a are put into contact in vacuum, the elements are directly bonded to achieve strong bonding. Since impurities are absent from the bonding interface, removal of impurities after bonding is not required, thereby suppressing breakage of a crystal near the bonding interface.

(Step 3) Next, as shown in Fig. 1(c), the surface 2a of the piezoelectric substrate 2 and the surface 10a of the supporting substrate 10a are bonded together to form a substrate bonded body 40.

In the case of the LiTaO₃ piezoelectric substrate 2 and the Si supporting substrate 10, since the substrates 2 and 10 have different linear thermal expansion coefficients, room-temperature direct bonding is preferably performed, in which the substrate surfaces 2a and 10a are activated with plasma at room temperature and bonded in vacuum.

After the LiTaO₃ piezoelectric substrate 2 and the Si supporting substrate 10 are bonded, the substrates 2 and 10 are heated at 500°C. As a result, microcavities are produced, along the surface 2a, in the defective layer 4 at a depth of 1 µm from the surface 2a of the LiTaO₃ piezoelectric substrate 2 implanted with H⁺ ions, and the cavities are grown by heating.

In order to strengthen bonding of elements, a small amount (several nm) of metal elements such as Fe may be deposited at the bonding interface. Metal elements are easily contaminated by oxidation reaction in air. Therefore, metal ions are preferably deposited immediately before bonding in a bonding chamber under pressure reduced to vacuum.

(Step 4) Next, as shown in Fig. 1(d), the piezoelectric substrate 2 and the supporting substrate 10 in the substrate bonded body 40 are separated at the defective layer 4 formed in the piezoelectric substrate 2 so that a separation layer 3 between the surface 2a of the piezoelectric substrate 2 and the defective layer 4 is separated from the piezoelectric substrate 2 and bonded to the supporting substrate 10 to form the composite piezoelectric substrate 30.

For example, since the substrates 2 and 10 are separated along microcavities formed in the defective layer 4 at a depth of 1 µm from the surface 2a of the LiTaO₃ piezoelectric substrate 2, the composite piezoelectric substrate 30 in which the separation layer 3 including a LiTaO₃ thin film with a thickness of 1 µm is bonded to the surface 10a of the supporting substrate 10 is separated from the LiTaO₃ piezoelectric substrate 2 in which the separation layer 3 including a LiTaO₃ thin film is separated from the surface 2a side.

(Step 5) Next, as schematically shown in Figs. 1(e-1) and (e-2), the surfaces 2a and 3a of the piezoelectric substrate 2 and the composite piezoelectric substrate 30, which are fracture surfaces with irregularity formed thereon, are polished to smooth surfaces 2k and 3k of the piezoelectric substrate 2 and the composite piezoelectric substrate 30 as shown in Figs. 1(f-1) and (f-2).

For example, the surface 3a of the composite piezoelectric substrate 30 on which a fracture surface of the separation layer 3 including a LiTaO₃ thin film appears and the surface 2a of the LiTaO₃ piezoelectric substrate 2 from which the separation layer 3 including a LiTaO₃ thin film is separated are surfaces with RMS (root mean square) roughness of about 1 mm. Therefore, the surfaces 2a and 3a are smoothed by polishing to remove a thickness of about 100 nm.

(Step 6) In the composite piezoelectric substrate 30 having the smoothed surface 3k, polarization is performed for correcting polarization inversion of the piezoelectric material of the separation layer 3. For example, the separation layer 3 including a LiTaO₃ thin film and having the smoothed surface 3a is polarized by applying pulses of voltage of 22 kV at 400°C, each pulse's duration being 5 ms.

Part of the atoms constituting a piezoelectric crystal are positively or negatively charged and ionized. For example, when an electric field is applied to the ionized atoms, positively charged ions slightly shift in the crystal to the cathode side, and negatively charged ions slightly shift to the anode side to induce dipoles. This phenomenon is referred to as electric polarization. There are crystals which can maintain a polarization state even if application of an electric field is stopped, and this state is referred to as the above-described spontaneous polarization. When a large amount of ions are implanted with high energy into a piezoelectric crystal spontaneously polarized, the shift states of ions are changed to cause polarization inversion. Since partial polarization inversion induces deterioration of piezoelectricity and is thus undesired.

Therefore, polarization inversion can be repaired by polarization after ion implantation. For example, in the case of LiNbO₃, an electric field of 22 kV/mm is applied in a heating atmosphere at 700°C. Polarization is preferably performed after the separation step, and the temperature is 200°C to 1200°C in consideration of the melting points of the supporting substrate and the electrode and the difference between the thermal expansion coefficients. Since the coercive electric field decreases as the temperature increases, the electric field applied can be suppressed to a lower field. In addition, the electric field is preferably intermittently applied with each pulse's duration within the range of 1 µs to 1 minute because damage to a crystal due to a direct-current electric field can be suppressed. Further, heating at 200°C or more is preferred because strain of the crystal caused by ion implantation is reduced. The heating temperature for removing crystal strain is at least 100°C lower than Curie temperature in order to avoid depolarization.

Although deterioration of piezoelectricity such as polarization inversion can be repaired by polarization in Step 6, deterioration of piezoelectricity such as polarization inversion is preferably suppressed as much as possible before Step 6 because a load is applied to the crystal. In addition, there are piezoelectric materials difficult to polarize according to crystal materials and crystal orientations, a measure for suppressing deterioration of piezoelectricity before Step 6 is important.

Polarization is produced by slight shift of the constituent elements of an ionized piezoelectric crystal. The amount of energy for slight shift is smaller than the amount of energy of deviation of the constituent elements from a crystal unit. Therefore, when ions are implanted in the same direction as the shift direction of ions showing spontaneous polarization, polarization inversion of spontaneous polarization can be suppressed.

For example, in the case of LiTaO₃ or LiNbO₃, Li ions and Ta ions or Nb ions slightly shift in the +C axis direction, and thus ions are preferably implanted from the -C axis direction to the +C axis direction. In addition, when the angle θ of the C axis with respect to the direction of ion implantation is within the range of -90° < θ < +90°, the effect can be obtained.

In step 4, separation is preferably performed at a temperature lower than the Curie temperature of the piezoelectric material. When separation temperature exceeds the Curie temperature, polarization is released, thereby degrading piezoelectricity.

According to the finding by the inventors of the present invention, the heating temperature required for separation at the defective layer in step 4 is 500°C to 600°C. The Curie temperature of a LiTaO₃ wafer generally supplied to electronic parts is as low as about 600°C, and the heating temperature necessary for separation is close to the Curie temperature. Therefore, piezoelectricity is easily degraded. When the composition ratio x of Li to Ta or Nb in LiTaO₃ or LiNbO₃ is 48.0% ≤ x ≤ 49.5%, this is referred to as a "congruent composition" and is used for wafers supplied as the piezoelectric substrates for electronic parts in a large amount. On the other hand, when the composition ratio is 49.5% ≤ x ≤ 50.5%, this is referred to as a "stoichiometric composition". In the case of LiTaO₃, the congruent composition has a Curie temperature of as low as 590°C to 650°C, and the stoichiometric composition has a Curie temperature of 660°C to 700°C. Therefore, when LiTaO₃ is used, the stoichiometric composition in which the Li composition ration to Ta is 49.5% ≤ x ≤ 50.5% is preferred because deterioration of piezoelectricity during heating in step 4 can be suppressed.

In the case of LiNbO₃, the congruent composition has a Curie temperature of 1100°C to 1180°C, and the stoichiometric composition has a Curie temperature of 1180°C to 1200°C.

When like LiTaO₃ and LiNbO₃, a piezoelectric material has pyroelectricity, charge is accumulated on a substrate surface due to heating and cooling in Step 4. When an electric field due to the charged accumulated on the surface is applied from a direction opposite to the polarization direction beyond the coercive electric field of a piezoelectric material, polarization is inverted, thereby degrading piezoelectricity. Since an electric field is applied from a direction opposite to the polarization direction during any one of heating and cooling in Step 4, piezoelectricity is easily degraded.

The inventors of the present invention found that deterioration of piezoelectricity can be suppressed by increasing the conductivity of a piezoelectric material and controlling the pace of temperature changes so that the electric field due to pyroelectric charge is smaller than the coercive electric field of the piezoelectric material.

In Example 1, a wafer treated by increasing the conductivity of LiTaO₃ to 4 x 10₁₀ S/cm was used, and the pace of heating and cooling was decreased so that the surface potential was 200 V or less in step 4, thereby suppressing deterioration of piezoelectricity. Methods known as treatment for increasing conductivity of LiTaO₃ and LiNbO₃ include a method of annealing at a high temperature in a low-oxygen atmosphere as in Japanese Unexamined Patent Application Publication No. 2004-328712 and a method of heating in a metal powder as in Japanese Unexamined Patent Application Publication Nos. 2005-119906 and 2005-179117.

An example of a composite piezoelectric substrate manufactured by the above-described manufacturing method was observed. That is, a LiTaO₃ substrate was used as the piezoelectric substrate, and also a LiTaO₃ substrate was used as the supporting substrate, and surfaces of the piezoelectric substrate and the supporting substrate were smoothed by CMP. Then, the surfaces of the piezoelectric substrate and the supporting substrate were irradiated with Ar ion beams in vacuum to clean and activate the surfaces. The surfaces of the substrates were put into contact and bonded to achieve strong bonding by direct bonding of elements of the substrates. Then, the outer shape of the resulting composite piezoelectric substrate was photographed. In the photograph, visible cavities were not observed in the bonding interface. As a result of TEM (transmission electron microscope) observation of the crystal arrangement of the bonding interface, the ordered crystal arrangement was observed.

The composite piezoelectric substrate 30 manufactured by the above-described manufacturing method includes the piezoelectric separation layer 3 formed on the surface thereof and thus can be used for forming an acoustic wave device. The remaining piezoelectric substrate 2 is reused as a material for manufacturing a next composite piezoelectric substrate 30.

Next, steps for manufacturing a SAW device are described with reference to a sectional view of Fig. 5.

As shown in Fig. 5(a), the composite piezoelectric substrate 30 manufactured by the above-described steps 1 to 6 is prepared, and an IDT electrode 15 and the like are formed on the surface 3k of the composite piezoelectric substrate 30.

For example, an aluminum film was patterned by photolithography technique on the smoothed surface of the separation layer 3 including a LiTaO₃ thin film exposed on the surface 3k of the composite piezoelectric substrate 30 in which the separation layer 3 including a LiTaO₃ thin film is bonded to the surface 10a of the supporting substrate 10 to form conductor patterns such as the IDT electrode 15, a pad electrode (not shown), wiring (not shown) for connecting the IDT electrode 15 and the pad electrode, and the like. As a result, a SAW device such as a SAW filter is manufactured.

The manufacture of a SAW device by the above-described steps can produce the following effects:
(1) When a SAW device is manufactured, the piezoelectric material and crystal orientation influence the electromechanical coupling coefficient, frequency temperature behavior, and sonic speed, thereby causing important influence on the frequency, band width, insertion loss, and the like of the SAW device. When the piezoelectric material and crystal orientation have a higher degree of selection freedom, an excellent SAW device can be formed.
   Namely, when a piezoelectric thin film is formed by the deposition method such as sputtering, CVD, or the like, the material of the thin film and crystal orientation are limited. That is, AlN and ZnO can be used as materials of the thin film, and there are few types of films which can be formed by the deposition method. In addition, it is difficult to form a piezoelectric single crystal, and only C-axis oriented films can be generally obtained. Therefore, it is difficult to excite SH-type SAW because the piezoelectric axis is aligned only in the vertical direction.
   On the other hand, the method of separating a thin film from a piezoelectric single crystal according to the present invention has a high degree of freedom of piezoelectric crystal orientation and thus can produce an excellent 36°-46° Y-cut piezoelectric substrate for excitation of SH-type SAW.
(2) The Si substrate is inexpensive as compared with piezoelectric substrates such as expensive LiTaO₃ and LiNbO₃ substrates, and a quartz substrate, and the like, which exhibit a low growth rate of single crystal and difficulty in slicing due to easy fracture and which are expensive due to rare raw materials such as Li and Ta.
   That is, an expensive piezoelectric substrate is generally used for a SAW device wafer. In contrast, in the composite piezoelectric substrate of the present invention, only an inexpensive Si substrate and a piezoelectric thin film are used for manufacturing a SAW device wafer. In addition, several tens to several hundreds thin films can be obtained from a piezoelectric substrate, thereby suppressing the amount of the material used to a negligible level. Therefore, the amount of rare expensive Li and Ta used can be suppressed, and an inexpensive piezoelectric substrate with small environmental load can be formed.
(3) A RF filter for cellular phone is preferably resistant to the application of electric power of 1 to 2 W. The electric power resistance of a SAW filter is significantly influenced by the temperature of an IDT region when an electric signal is supplied. When the temperature of the IDT region is increased to 250°C by application of electric power, the time until fracture of the SAW filter is significantly shortened. The temperature of the IDT region is increased by the phenomenon that Joule heat due to electric ohmic loss and heat generated by elastic sound absorption are not sufficiently radiated due to the low thermal conductivity of a piezoelectric substrate. A piezoelectric substrate composed of only a piezoelectric material such as LiTaO₃ or LiNbO₃ has lower thermal conductivity than Si and thus has low heat radiation property. The composite piezoelectric substrate of the present invention can have thermal conductivity equivalent to Si and thus has high heat radiation property. Therefore, the substrate of the present invention can resist the application of large electric power.
(4) The thickness of an ultrathin piezoelectric material is determined by the energy of ion implantation. Therefore, unlike in polishing, the thickness does not depend on waviness of the substrate, and thus the ultrathin piezoelectric material with a stable thickness can be formed. The thickness of the piezoelectric thin film is important because it determines the SAW sound speed (the frequency is determined because frequency = sound speed/wavelength). The composite piezoelectric substrate of the present invention permits the formation of a piezoelectric thin film having a uniform thickness, thereby stabilizing the characteristics of the SAW device.
(5) A 42° Y-cut LiTaO₃ substrate has a -Z axis inclined at 42°C on the front surface side. The Li atoms and Ta atoms constituting LiTaO₃ slightly shift to the back side (+Z axis side) and produce spontaneous polarization. In the present invention, polarization inversion is suppressed by ion implantation from the -Z axis side.
(6) The composite piezoelectric substrate manufactured through steps 1 to 6 can be used for not only a SAW filter but also a filter using a boundary wave, a plate wave such as a Lamb wave, or the like. In the case of a boundary wave, an element portion may be formed on the composite piezoelectric substrate as in Example 2 described below. When a plate wave is used, as in Example 3 described below, the supporting substrate may be etched from the back side to expose the piezoelectric separation layer from the back side.
(7) Since Si has a smaller coefficient of thermal expansion than LiTaO₃, the composite piezoelectric substrate having the LiTaO₃ separation film bonded to the Si supporting substrate is capable of suppressing the temperature coefficient of resonant frequency.

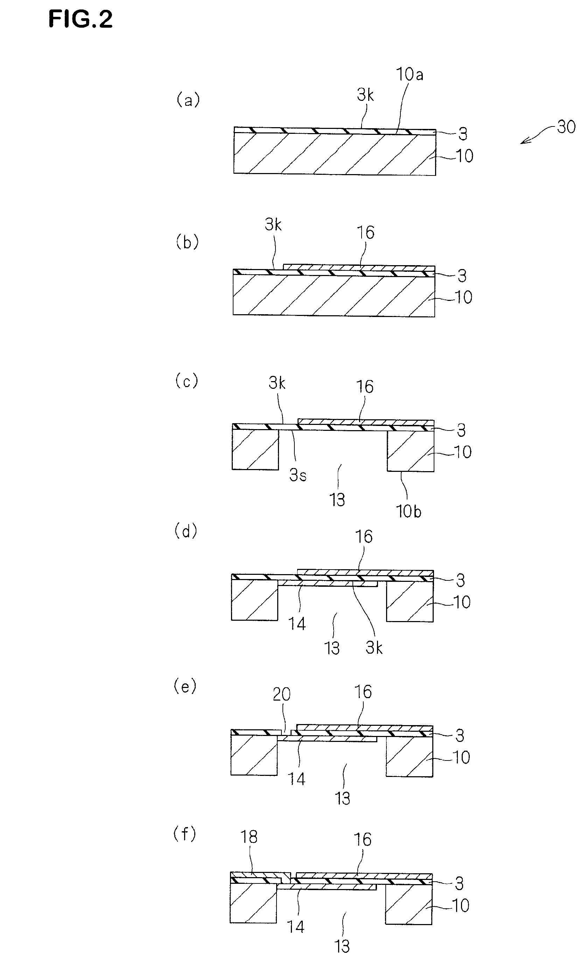

### <EXAMPLE 2> A BAW (bulk acoustic wave) device of Example 2 is described with reference to Fig. 2. Fig. 2 is a sectional view showing steps for manufacturing a BAW device.

The BAW device of Example 2 is manufactured through the following steps.

First, as shown in Fig. 2(b), a composite piezoelectric substrate 30 is prepared. The composite piezoelectric substrate 30 having the 20° Y-cut LiTaO₃ separation layer 3 bonded to the surface 10a of the supporting substrate 10 is formed by the same steps as steps 1 to 5 of Example 1 using a 20° Y-cut LiTaO₃ piezoelectric substrate and a Si supporting substrate 10.

Next, as shown in Fig. 2(b), an upper electrode 16 is formed on the surface 3k of the composite piezoelectric substrate 30. For example, the upper electrode 16 is formed on the surface 3k of the LiTaO₃ separation layer 3 by an electron beam evaporation method and a photolithography method using aluminum.

Next, as shown in Fig. 2(c), a hole 13 is formed in the supporting substrate 10 to expose the back surface 3s of the separation layer 3. For example, the Si supporting substrate 10 is etched from the back side 10b opposite to the separation layer 3 by photolithography and reactive ion etching to form the hole 13, thereby exposing the back surface 3s of the piezoelectric separation layer 3.

Next, as shown in Fig. 2(d), a lower electrode 14 is formed on the back surface 3s of the separation layer 3. For example, the lower electrode 14 is formed on the back surface 3s of the LiTaO₃ separation layer 3 by an electron beam evaporation method and a photolithography method using aluminum.

Next, as shown in Fig. 2(e), a hole 20 is formed in the separation layer 3 to expose the lower electrode 14. For example, the hole 20 is formed from the surface 3k side of the LiTaO₃ separation layer 3 by photolithography and reactive ion etching.

Then, as shown in Fig. 2(f), wiring 18 is formed to be electrically connected to the lower electrode 14 through the hole 20. For example, the wiring 18 is formed by photolithography and an evaporation method using aluminum so as to be connected to the lower electrode 14 through the hole 20 of the LiTaO₃ separation layer 3. Although not shown in the drawing, in order to decrease the electric resistance of the wiring 18, aluminum is thickly deposited on a region other than a vibration region of the bulk acoustic wave device (a region where the lower electrode 14 and the upper electrode 16 face each other with the separation layer 3 provided therebetween), and the wiring 18 is connected to an external terminal, followed by packaging.

The manufacture of a BAW device by the above-described steps can produce the following effects:
(1) When a BAW device is manufactured, the piezoelectric material and crystal orientation influence the electromechanical coupling coefficient, frequency temperature behavior, and sonic speed, thereby causing important influence on the frequency, band width, insertion loss, and the like of the BAW device. When the piezoelectric material and crystal orientation have a higher degree of selection freedom, an excellent BAW device can be formed. When a piezoelectric thin film is formed by the deposition method such as sputtering, CVD, or the like, the material of the thin film and crystal orientation are limited. That is, AIN and ZnO can be used as materials of the thin film, and there are few types of films which can be formed by the deposition method. In addition, it is difficult to form a piezoelectric single crystal, and only C-axis oriented films can be generally obtained. Therefore, it is difficult to excite thickness-shear BAW because the piezoelectric axis is aligned only in the vertical direction.
   On the other hand, the method of separating a thin film from a piezoelectric single crystal according to the present invention has a high degree of freedom of piezoelectric crystal orientation and thus can produce an excellent substrate for excitation of thickness-shear BAW.
   In addition, the energy trapped state and spurious application of the BAW device are determined by a dispersion relation of a bulk wave to be excited. However, a high-Q bulk acoustic wave device satisfying energy trapping and spurious suppression can be formed by controlling the material and crystal orientation.
(2) Piezoelectric substrates such as a LiTaO₃ substrate, a LiNbO₃ substrate, a quartz substrate, and the like exhibit a low growth rate of single crystal and difficulty in slicing due to easy fracture and are expensive due to rare raw materials such as Li and Ta. A possible method for forming a composite piezoelectric substrate including a single crystal thin film formed thereon is a method of bonding a Si substrate and a piezoelectric substrate and then thinning the piezoelectric material by CMP (chemical mechanical polishing). In this case, a Si substrate and a piezoelectric substrate are required for forming a composite piezoelectric substrate, and thus the material efficiency of an expensive piezoelectric material is low.
   In the composite piezoelectric substrate of the present invention, only an inexpensive Si substrate and a piezoelectric thin film are used for manufacturing a BAW device wafer. In addition, several tens to several hundreds piezoelectric thin films can be obtained from a piezoelectric substrate, thereby suppressing the amount of the material used to a negligible level. Therefore, the amount of rare expensive Li and Ta used can be suppressed, and an inexpensive piezoelectric substrate with small environmental load can be formed.
(3) The thickness of an ultrathin piezoelectric material is determined by the energy of ion implantation. Therefore, unlike in polishing, the thickness does not depend on waviness of the substrate, and thus the ultrathin piezoelectric material with a stable thickness can be formed. The thickness of the piezoelectric thin film is important because it determines the BAW wavelength (the frequency is determined because frequency = sound speed/wavelength).

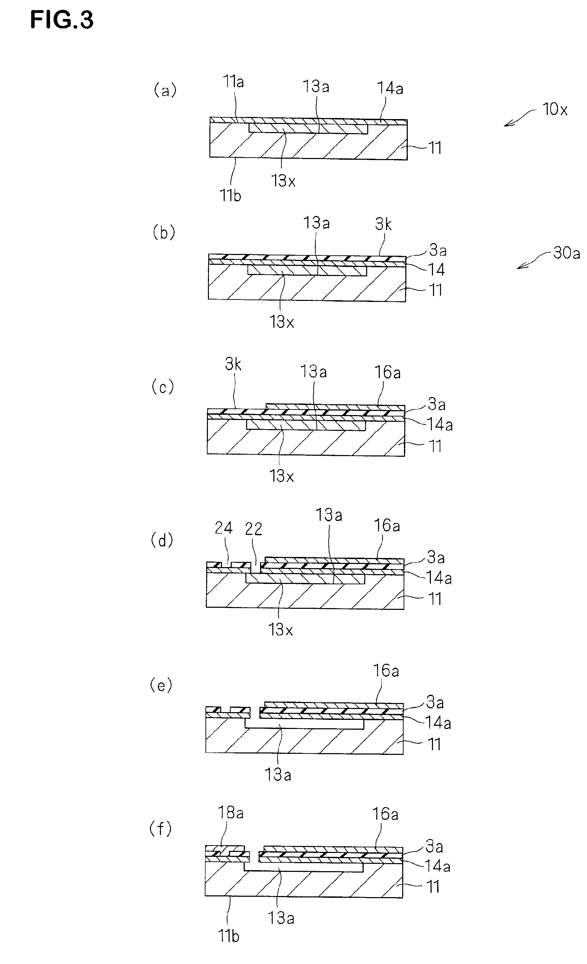

### <EXAMPLE 3> A BAW device of Example 3 is described with reference to Figs. 3 an 4. Fig. 3 is a sectional view showing steps for manufacturing a BAW device, and Fig. 4 is a plan view of a BAW device.

The BAW device of Example 3 is manufactured through the following steps.

First, a composite piezoelectric substrate is prepared by the same steps as steps 1 to 5 of Example 1.

Namely, in step 1, a 20° Y-cut LiTaO₃ piezoelectric substrate and a supporting substrate 10x shown in Fig. 3(a) are prepared. Unlike in Example 1, the supporting substrate 10x is prepared by forming a recess 13a in a Si supporting substrate 11 by reactive ion etching, forming a sacrifice layer 13x in the recess 13a, smoothing a surface 11a of the Si supporting substrate 11 by CMP, and forming a lower electrode 14a by sputtering using W (tungsten). In step 2, like in Example 2, ions implanted into the piezoelectric substrate. In step 3, the piezoelectric substrate is metallically bonded to the lower electrode 14a of the supporting substrate 10x to form a substrate bonded body. In step 4, like in Example 1, the substrate bonded body is separated at a defective layer of the piezoelectric substrate. In step 5, the surfaces of the piezoelectric substrate and the supporting substrate are smoothed to prepare a composite piezoelectric substrate 30a having the 20° Y-cut LiTaO₃ separation layer 3a as shown in Fig. 3(b).

Next, as shown in Fig. 3(c), an upper electrode 16a is formed on the surface 3k of the LiTaO₃ separation layer 3a by an electron beam evaporation method and a photolithography method using aluminum.

Next, as shown in Fig. 3(d), a hole 22 reaching the sacrifice layer 13x and a hole 24 reaching a lower electrode 14a are formed in the separation layer 3a and the lower electrode 14a by photolithography and reactive ion etching.

Next, as shown in Fig. 3(e), the sacrifice layer 13x is removed by dry etching through the hole 22 reaching the sacrifice layer 13x.

Then, as shown in Fig. 3(f) and Fig. 4, wiring 18a is formed by photolithography and an evaporation method using aluminum to be connected to the lower electrode 14a through the hole 24 reaching the lower electrode 14a. Although not shown in the drawing, in order to decrease the electric resistance of the wiring 18a, aluminum is thickly deposited on a region other than a vibration region of the bulk acoustic wave device (a region where the lower electrode 14a and the upper electrode 16a face each other with the separation layer 3a provided therebetween), and the wiring 18a is connected to an external terminal, followed by packaging.

When like in Example 2, the hole 13 is formed in the back surface 10b of the supporting substrate 10, it is necessary to cover the back surface 10b side by laminating another substrate. However, in the structure of Example 3, a hole is not formed in the supporting substrate 11, and thus closing the back surface side is not required. The other effects are the same as in Example 2.

<Summary> When a composite piezoelectric substrate is manufactured by the above-described method, an ultrathin piezoelectric film can be formed by efficiently using a piezoelectric material.

The present invention is not limited to the above-described embodiment, and various modification can be made in carrying out the present invention.

For example, the composite piezoelectric substrate manufactured by the method of the present invention can be used for a SAW device, a BAW device, a sensor element, a flexural vibrator, and other various devices.

## Claims

1. A method for manufacturing a composite piezoelectric substrate (30) comprising:
a first step of preparing a piezoelectric substrate (2) and a supporting substrate (10);
a second step of implanting ions from a surface (2a) of the piezoelectric substrate (2) to form a defective layer (4) in a region having a predetermined depth from the surface (2a) of the piezoelectric substrate;
a third step of bonding the supporting substrate (10) to the surface (2a) of the piezoelectric substrate (2) to form a substrate bonded body (40);
a fourth step of separating the substrate bonded body (40) at the defective layer (4) formed in the piezoelectric substrate so that a separation layer (3) between the surface (2a) of the piezoelectric substrate and the defective layer (4) is separated from the piezoelectric substrate and bonded to the supporting substrate (10) to form a composite piezoelectric substrate (30); and
a fifth step of smoothing the surface of the separation layer (3) of the composite piezoelectric substrate;
**characterized in that** there is further provided:
a cleaning activation step of removing impurities adhering to at least one of the surface (2a) of the piezoelectric substrate in which the defective layer is formed and a surface (10a) of the supporting substrate to directly expose constituent atoms of the surface and activate it; and
a polarization step of polarizing the separation layer (3) of the composite piezoelectric substrate (30) after the second step and before the cleaning activation step or after the cleaning activation step;
and **in that** the third step bonds the supporting substrate (10) to the surface (2a) of the piezoelectric substrate (2) after the cleaning activation step.

2. A method for manufacturing a composite piezoelectric substrate (30) comprising:
a first step of preparing a piezoelectric substrate (2) and a supporting substrate (10);
a second step of implanting ions from a surface (2a) of the piezoelectric substrate (2) to form a defective layer (4) in a region having a predetermined depth from the surface (2a) of the piezoelectric substrate;
a third step of bonding the supporting substrate (10) to the surface (2a) of the piezoelectric substrate (2) to form a substrate bonded body (40);
a fourth step of separating the substrate bonded body (40) at the defective layer (4) formed in the piezoelectric substrate so that a separation layer (3) between the surface (2a) of the piezoelectric substrate and the defective layer (4) is separated from the piezoelectric substrate and bonded to the supporting substrate (10) to form a composite piezoelectric substrate (30); and
a fifth step of smoothing the surface of the separation layer (3) of the composite piezoelectric substrate;
**characterized in that**:
there is further provided a cleaning activation step of removing impurities adhering to at least one of the surface (2a) of the piezoelectric substrate in which the defective layer is formed and a surface (10a) of the supporting substrate to directly expose constituent atoms of the surface and activate it; and
spontaneous polarization shifts constituent atoms of the piezoelectric substrate in a first direction and, in ion implantation in the second step, the ions are implanted in the same direction as said first direction.

3. The method for manufacturing a composite piezoelectric substrate according to Claim 2, further comprising a polarization step of polarizing the separation layer (3) of the composite piezoelectric substrate (30) after the second step and before the cleaning activation step or after the cleaning activation step;
and in that the third step bonds the supporting substrate (10) to the surface (2a) of the piezoelectric substrate (2) after the cleaning activation step.

4. The method for manufacturing a composite piezoelectric substrate according to any one of Claims 1 to 3, wherein a lithium-based piezoelectric material is used for the piezoelectric substrate (2).

## Patentansprüche

1. Verfahren zum Herstellen eines piezoelektrischen Verbundsubstrats (30), umfassend:
einen ersten Schritt zum Ausbilden eines piezoelektrischen Substrats (2) und eines Stützsubstrats (10),
einen zweiten Schritt zum Implantieren von Ionen von einer Oberfläche (2a) des piezoelektrischen Substrats (2) zum Bilden einer Defektschicht (4) in einer Region mit einer zuvor festgelegten Tiefe von der Oberfläche (2a) des piezoelektrischen Substrats,
einen dritten Schritt zum Bonden des Stützsubstrats (10) an die Oberfläche (2a) des piezoelektrischen Substrats (2) zum Bilden eines substratgebondeten Körpers (40),
einen vierten Schritt zum Trennen des substratgebondeten Körpers (40) an der in dem piezoelektrischen Substrat gebildeten Defektschicht (4) so, dass eine Trennungsschicht (3) zwischen der Oberfläche (2a) des piezoelektrischen Substrats und der Defektschicht (4) von dem piezoelektrischen Substrat getrennt wird und an das Stützsubstrat (10) gebondet wird, um ein piezoelektrisches Verbundsubstrat (30) zu bilden, und
einen fünften Schritt zum Glätten der Oberfläche der Trennungsschicht (3) des piezoelektrischen Verbundsubstrats,
**dadurch gekennzeichnet, dass** ferner vorgesehen sind:
ein Reinigungsaktivierungsschritt zum Entfernen von Verunreinigungen, die an der Oberfläche (2a) des piezoelektrischen Substrats, in der die Defektschicht ausgebildet ist, und/oder einer Oberfläche (10a) des Stützsubstrats anhaften, um konstutierende Atome der Oberfläche direkt frei zu legen und die Oberfläche zu aktivieren, und
ein Polarisationsschritt zum Polarisieren der Trennungsschicht (3) des piezoelektrischen Verbundsubstrats (30) nach dem zweiten Schritt und vor dem Reinigungsaktivierungsschritt oder nach dem Reinigungsaktivierungsschritt,
und dadurch, dass der dritte Schritt das Stützsubstrat (10) nach dem Reinigungsaktivierungsschritt an die Oberfläche (2a) des piezoelektrischen Substrats (2) bondet.

2. Verfahren zum Herstellen eines piezoelektrischen Verbundsubstrats (30), umfassend:
einen ersten Schritt zum Ausbilden eines piezoelektrischen Substrats (2) und eines Stützsubstrats (10),
einen zweiten Schritt zum Implantieren von Ionen von einer Oberfläche (2a) des piezoelektrischen Substrats (2) zum Bilden einer Defektschicht (4) in einer Region mit einer zuvor festgelegten Tiefe von der Oberfläche (2a) des piezoelektrischen Substrats,
einen dritten Schritt zum Bonden des Stützsubstrats (10) an die Oberfläche (2a) des piezoelektrischen Substrats (2) zum Bilden eines substratgebondeten Körpers (40),
einen vierten Schritt zum Trennen des substratgebondeten Körpers (40) an der in dem piezoelektrischen Substrat gebildeten Defektschicht (4) so, dass eine Trennungsschicht (3) zwischen der Oberfläche (2a) des piezoelektrischen Substrats und der Defektschicht (4) von dem piezoelektrischen Substrat getrennt wird und an das Stützsubstrat (10) gebondet wird, um ein piezoelektrisches Verbundsubstrat (30) zu bilden, und
einen fünften Schritt zum Glätten der Oberfläche der Trennungsschicht (3) des piezoelektrischen Verbundsubstrats,
**dadurch gekennzeichnet, dass**
ferner ein Reinigungsaktivierungsschritt zum Entfernen von Verunreinigungen, die an der Oberfläche (2a) des piezoelektrischen Substrats, in der die Defektschicht ausgebildet ist, und/oder einer Oberfläche (10a) des Stützsubstrats anhaften, bereitgestellt ist, um konstutierende Atome der Oberfläche direkt frei zu legen und die Oberfläche zu aktivieren, und
eine spontane Polarisation konstutierende Atome des piezoelektrischen Substrats in einer ersten Richtung verschiebt, und die Ionen bei der Ionenimplantation in dem zweiten Schritt in der gleichen Richtung wie die ersten Richtung implantiert werden.

3. Verfahren zum Herstellen eines piezoelektrischen Verbundsubstrats nach Anspruch 2, das ferner einen Polarisationsschritt zum Polarisieren der Trennungsschicht (3) des piezoelektrischen Verbundsubstrats (30) nach dem zweiten Schritt und vor dem Reinigungsaktivierungsschritt oder nach dem Reinigungsaktivierungsschritt umfasst, und
wobei der dritte Schritt das Stützsubstrat (10) nach dem Reinigungsaktivierungsschritt an die Oberfläche (2a) des piezoelektrischen Substrats (2) bondet.

4. Verfahren zum Herstellen eines piezoelektrischen Verbundsubstrats nach einem der Ansprüche 1 bis 3, wobei ein Lithium-basiertes piezoelektrisches Material für das piezoelektrische Substrat (2) verwendet wird.

## Revendications

1. Procédé de fabrication d'un substrat piézoélectrique composite (30) comprenant :
une première étape de préparation d'un substrat piézoélectrique (2) et d'un substrat de support (10) ;
une seconde étape d'implantation d'ions depuis une surface (2a) du substrat piézoélectrique (2) pour former une couche défectueuse (4) dans une région ayant une profondeur prédéterminée par rapport à la surface (2a) du substrat piézoélectrique ;
une troisième étape de liaison du substrat de support (10) à la surface (2a) du substrat piézoélectrique (2) pour former un corps à substrat lié (40) ;
une quatrième étape de séparation du corps à substrat lié (40) au niveau de la couche défectueuse (4) formée dans le substrat piézoélectrique de sorte qu'une couche de séparation (3) entre la surface (2a) du substrat piézoélectrique et la couche défectueuse (4) soit séparée du substrat piézoélectrique et liée au substrat de support (10) afin de former un substrat piézoélectrique composite (30) ; et
une cinquième étape de lissage de la surface de la couche de séparation (3) du substrat piézoélectrique composite ;
**caractérisé en ce qu'**il comprend en outre :
une étape d'activation par nettoyage consistant à enlever les impuretés adhérant à au moins une parmi la surface (2a) du substrat piézoélectrique dans lequel la couche défectueuse est formée et une surface (10a) du substrat de support pour exposer directement les atomes constitutifs de la surface et l'activer ; et
une étape de polarisation consistant à polariser la couche de séparation (3) du substrat piézoélectrique composite (30) après la seconde étape et avant l'étape d'activation par nettoyage ou après l'étape d'activation par nettoyage ;
et **en ce que** la troisième étape lie le substrat de support (10) à la surface (2a) du substrat piézoélectrique (2) après l'étape d'activation par nettoyage.

2. Procédé de fabrication d'un substrat piézoélectrique composite (30) comprenant :
une première étape de préparation d'un substrat piézoélectrique (2) et d'un substrat de support (10) ;
une seconde étape d'implantation d'ions depuis une surface (2a) du substrat piézoélectrique (2) pour former une couche défectueuse (4) dans une région ayant une profondeur prédéterminée par rapport à la surface (2a) du substrat piézoélectrique ;
une troisième étape de liaison du substrat de support (10) à la surface (2a) du substrat piézoélectrique (2) pour former un corps à substrat lié (40) ;
une quatrième étape de séparation du corps à substrat lié (40) au niveau de la couche défectueuse (4) formée dans le substrat piézoélectrique de sorte qu'une couche de séparation (3) entre la surface (2a) du substrat piézoélectrique et la couche défectueuse (4) soit séparée du substrat piézoélectrique et liée au substrat de support (10) afin de former un substrat piézoélectrique composite (30) ; et
une cinquième étape de lissage de la surface de la couche de séparation (3) du substrat piézoélectrique composite,
**caractérisé en ce que** :
il comprend en outre une étape d'activation par nettoyage consistant à enlever les impuretés adhérant à au moins une parmi la surface (2a) du substrat piézoélectrique dans lequel la couche défectueuse est formée et une surface (10a) du substrat de support pour exposer directement les atomes constitutifs de la surface et l'activer ; et
une polarisation spontanée déplace les atomes constitutifs du substrat piézoélectrique dans une première direction et, dans l'implantation ionique de la seconde étape, les ions sont implantés dans la même direction que ladite première direction.

3. Procédé de fabrication d'un substrat piézoélectrique composite selon la revendication 2, comprenant en outre une étape de polarisation consistant à polariser la couche de séparation (3) du substrat piézoélectrique composite (30) après la seconde étape et avant l'étape d'activation par nettoyage ou après l'étape d'activation par nettoyage ;
et en ce que la troisième étape lie le substrat de support (10) à la surface (2a) du substrat piézoélectrique (2) après l'étape d'activation par nettoyage.

4. Procédé de fabrication d'un substrat piézoélectrique composite selon l'une quelconque des revendications 1 à 3, dans lequel un matériau piézoélectrique à base de lithium est utilisé pour le substrat piézoélectrique (2).
